(19) Europäisches Patentamt

European Patent Office

Office européen des brevets

(11) **EP 2 474 997 A1**

(12) **EUROPEAN PATENT APPLICATION**

published in accordance with Art. 153(4) EPC

(43) Date of publication:
**11.07.2012 Bulletin 2012/28**

(21) Application number: **10813648.2**

(22) Date of filing: **25.08.2010**

(51) Int Cl.:
*H01L 21/027* (2006.01)          *G03F 7/20* (2006.01)
*H05G 2/00* (2006.01)

(86) International application number:
**PCT/JP2010/064386**

(87) International publication number:
**WO 2011/027699 (10.03.2011 Gazette 2011/10)**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **01.09.2009 JP 2009201848**

(71) Applicant: **IHI Corporation
Tokyo 135-8710 (JP)**

(72) Inventor: **KUWABARA Hajime
Tokyo 135-8710 (JP)**

(74) Representative: **Grünecker, Kinkeldey,
Stockmair & Schwanhäusser
Leopoldstrasse 4
80802 München (DE)**

(54) **PLASMA LIGHT SOURCE SYSTEM**

(57)     A plasma light source system includes a plurality of plasma light source 10 that periodically emits plasma light 8 from respective predetermined light emitting points la and a light collecting device 40 that collects the plasma light emitted from the plurality of light emitting points of the plasma light sources to a single light collecting point 9.

FIG. 3A

EP 2 474 997 A1

**Description**

Technical Field

The present invention relates to a plasma light source system for EUV radiation.

Background Art

Lithography which uses an extreme ultraviolet light source for the microfabrication of next-generation semiconductors has been expected. Lithography is a technique which reduces and projects light or beams onto a silicon substrate through a mask having a circuit pattern drawn thereon and forms an electronic circuit by exposing a resist material. The minimal processing dimensions of the circuit formed by optical lithography are basically dependent on the wavelength of the light source. Accordingly, the wavelength of the light source used for the development of next-generation semiconductors needs to be shortened, and thus a study for the development of such a light source has been conducted.

Extreme ultraviolet (EUV) is most expected as the next-generation lithography light source and the light has a wavelength in the range of approximately 1 to 100 nm. Since the light of the range has high absorptivity with respect to all materials and a transmissive optical system such as a lens may not be used, a reflective optical system is used. Further, it is very difficult to develop the optical system of the EUV light range, and only a restricted wavelength exhibits reflection characteristics.

Currently, a Mo/Si multilayer film reflection mirror with sensitivity of 13.5 nm has been developed. Then, lithography techniques obtained by the combination of the light of the wavelength and the reflection mirror is developed, it is expected that 30 nm or less of a processing dimension may be realized. In order to realize a new microfabrication technique, there is an immediate need for the development of a lithography light source with a wavelength of 13.5 nm, and radiant light from plasma with high energy density has gained attention.

The generation of light source plasma may be largely classified into laser produced plasma (LPP) and discharge produced plasma (DPP) driven by the pulse power technique. In DPP, the input power is directly converted into plasma energy. For this reason, DPP has better energy converting efficiency than that of LPP, and due to the small size has an advantage in that devices can be inexpensive.

The radiation spectrum from hot and highly dense plasma using DPP is basically determined by the temperature and the density of the target material. According to the calculation result for the atomic process of the plasma, in order to obtain plasma of the EUV radiation range, the electron temperature and the electron density are respectively optimized as about several 10 eV and $10^{18}$ cm$^{-3}$ in the case of Xe and Sn and are respectively optimized as about 20 eV and $10^{18}$ cm$^{-3}$ in the case of Li.

Furthermore, the plasma light source is disclosed in Non-Patent Documents 1 and 2 and Patent Document 1.

Prior Art Documents

Non-Patent Documents

[Non-Patent Document 1]
Hiroto Sato et al., "Discharge-Produced Plasma EUV Source for Microlithography", OQD-08-28
[Non-Patent Document 2]
Jeroen Jonkers, "High power extreme ultraviolet (EUV) light sources for future lithography", Plasma Sources Science and Technology, 15 (2006) S8-S16

Patent document

[Patent document 1]

Japanese Patent Application Laid-Open No. 2004-226244, "Extreme ultraviolet light source and semiconductor exposure apparatus"

Summary of the Invention

Problems to be Solved by the Invention

In the EUV lithography light source, there is demand for the average output to be high, the size of the light source to be minute, the amount of the scattering particles (debris) to be small, and the like. In the current state, the EUV emitting amount is extremely low compared to the output demand, and an increase in output is one of the great problems. However, when the input energy is set to be large to obtain a high output, damage caused by the thermal load reduces the lifespan of the plasma generating device or the optical system. Accordingly, in order to meet both high EUV output and low thermal load, high energy converting efficiency is essentially needed.

At the beginning of forming plasma, a great deal of energy is consumed for heating or ionization, and hot and highly dense radiating plasma EUV is generally expanded rapidly. For this reason, the radiation sustaining time $\tau$ is extremely short. Accordingly, in order to improve the converting efficiency, it is important to maintain the plasma in a high temperature and a highly dense state appropriate for EUV radiation for a long period of time (in an order of $\mu$sec).

Currently, the radiation time of the general EUV plasma light source is about 100 nsec, such that the output is extremely insufficient. In order to obtain both high converting efficiency and high average output for the industrial application, there is a need to attain several $\mu$sec of EUV radiation time for one shot. That is, in order to develop a plasma light source with high converting efficiency, there is a need to confine plasma with a temperature and a density state appropriate for the respective targets for several $\mu$sec (at least 1 $\mu$sec or more) to attain the stable EUV radiation.

The invention is made to solve the above-described problems. That is, it is an object of the invention to provide a plasma light source that remarkably increases the output of the plasma light and extends the lifespan of a device by suppressing the thermal load and the consumption of the electrode.

Means for Solving the Problems

According to the invention, there is provided a plasma light source system including: a plurality of plasma light sources that periodically emits plasma light from predetermined light emitting points; and a light collecting device that collects the plasma light from the plurality of light emitting points of the plasma light source to a single light collecting point.

According to the embodiment of the invention, the plurality of light emitting points of the plasma light sources may be installed on a same circumference about a single center axis, and the light collecting device may include a reflection mirror that is positioned on the center axis and reflects the plasma light from the light emitting points toward the light collecting point and a rotation device that rotates the reflection mirror about the center axis toward the plasma light sources when each plasma light source emits plasma light.

Further, the light collecting device may include a plurality of light collecting mirrors that collects the plasma light of the respective light emitting points toward the reflection mirror, and the plasma light of the respective light emitting points may be collected to a single light collecting point by the light collecting mirrors and the reflection mirror.

According to other embodiments of the invention, the light collecting point may be positioned on the center axis, and the reflection mirror may be a concave mirror that collects the plasma light from the light emitting point toward the light collecting point.

Further, the distance from the intersection point between the plane including the plurality of light emitting points and the center axis to each light emitting point and the distance to each light collecting point may be set to be equal to each other.

Further, according to other embodiments of the invention, the light collecting device may include a rotation body that installs the plurality of light emitting points of the plasma light sources on a same circumference about a single center axis, and a rotation device that rotates the rotation body about the center axis so that the light emitting points of the plasma light sources are positioned on a same position when the respective plasma light sources emit plasma light.

Further, the light collecting device may include a light collecting mirror that collects the plasma light from the same position toward the light collecting point.

Further, each of the plasma light sources may include a pair of opposite coaxial electrodes, a discharge environment maintaining device that supplies a plasma medium into the coaxial electrodes while maintaining a temperature and a pressure appropriate for the generation of plasma, and a voltage applying device that applies a discharge voltage having reversed polarities to the respective coaxial electrodes, and a tubular discharge may be formed between the pair of coaxial electrodes so as to seal plasma in the axial direction.

Advantageous Effect of the Invention

According to the structure of the invention, since the plurality of plasma light sources which periodically emits the plasma light from the predetermined light emitting points is provided, when the plasma light sources are sequentially operated, it is possible to remarkably increase the output of the generated plasma light while suppressing the thermal load of the individual light source.

Further, since the light collecting device which collects the plasma light emitted from the plurality of light emitting points of the plasma light source to the single light collecting point is provided, it is possible to periodically emit the plasma light from the single light collecting point as the lithography EUV light source.

According to the embodiment of the invention, the plurality of plasma light sources is installed on a same circumference, the light collecting point obtained by the light collecting system including the light collecting mirror and the reflection mirror is formed on the center axis of the circle, the reflection mirror installed at the center of the circle is disposed so as to collect the light on the perpendicular axis passing the center of the circle, and then the reflection surface of the reflection mirror is rotated so as to face the plasma light source in a manner of being synchronized with the light emitting timing of the individual plasma light source disposed on the circumference, thereby periodically emitting the plasma light which has a high output and a microscopic size from the single light collecting point.

Further, according to other embodiments of the invention, since the plasma light is collected to the light collecting point by once reflection using the single concave mirror, the reflection efficiency may be made to be high and the utilization efficiency of the generated EUV light may be made to be large.

Further, according to other embodiments of the invention, the plurality of plasma light sources is installed on a same circumference, the plasma light sources are rotated, and the discharge of the respective plasma light sources and the plasma light emission are performed at the timing at which the respective plasma light sources reach the position facing the light collecting mirror, thereby periodically emitting the plasma light which has a high output and a microscopic size from the single light collecting point.

Brief Description of the Drawings

Fig. 1 is a diagram showing an embodiment of a plasma light source according to the invention.
Fig. 2A is a diagram illustrating the operation when generating a planar discharge in the plasma light source of Fig. 1.
Fig. 2B is a diagram illustrating the operation when moving the planar discharge of the plasma light source of Fig. 1.
Fig. 2C is a diagram illustrating the operation when forming plasma of the plasma light source of Fig. 1.
Fig. 2D is a diagram illustrating the operation when forming a plasma confining magnetic field of the plasma light source of Fig. 1.
Fig. 3A is a plan view of a first embodiment of the plasma light source system according to the invention.
Fig. 3B is a side view of the first embodiment of the plasma light source system according to the invention.
Fig. 4A is a plan view of a second embodiment of the plasma light source system according to the invention.
Fig. 4B is a side view of the second embodiment of the plasma light source system according to the invention.
Fig. 5 is a diagram showing a first embodiment of the concave mirror shown in Fig. 4B.
Fig. 6 is a diagram showing a second embodiment of the concave mirror of Fig. 4B.
Fig. 7 is a diagram showing a third embodiment of the concave mirror of Fig. 4B.
Fig. 8A is a plan view of a third embodiment of the plasma light source system according to the invention.
Fig. 8B is a side view of the third embodiment of the plasma light source system according to the invention.

Description of Embodiments

Hereinafter, exemplary embodiments of the invention will be described on the basis of the accompanying drawings. Furthermore, the same reference numerals will be given to the similar parts in the respective drawings, and the repetitive description thereof will be omitted.

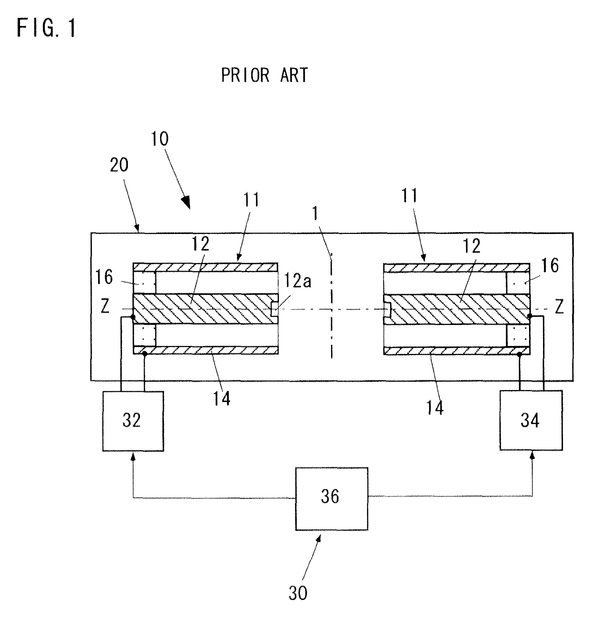

Fig. 1 is a diagram showing an embodiment of a plasma light source according to the invention, where a plasma light source 10 includes a pair of coaxial electrodes 11, a discharge environment maintaining device 20, and a voltage applying device 30.

The pair of coaxial electrodes 11 is disposed so as to face each other about a symmetry plane 1. Each coaxial electrode 11 includes a rod-shaped center electrode 12, a tubular guide electrode 14, and a ring-shaped insulator 16.

The rod-shaped center electrode 12 is a conductive electrode that extends on a single axis Z-Z.
The tubular guide electrode 14 surrounds the center electrode 12 with a predetermined gap therebetween, and holds a plasma medium therebetween. The plasma medium is, for example, a gas such as Xe, Sn, and Li.

The ring-shaped insulator 16 is an electrical insulator that has a hollow cylindrical shape and is positioned between the center electrode 12 and the guide electrode 14, and electrically insulates a gap between the center electrode 12 and the guide electrode 14.

In the pair of coaxial electrodes 11, the respective center electrodes 12 are positioned on the same axis Z-Z, and are positioned so as to be symmetrical to each other with a predetermined gap therebetween.

The discharge environment maintaining device 20 supplies the plasma medium into the coaxial electrode 11, and maintains the coaxial electrode 11 so as to have a temperature and a pressure which are appropriate for the generation of plasma. The discharge environment maintaining device 20 may be configured as, for example, a vacuum chamber, a temperature controller, a vacuum device, and a plasma medium supply device.

The voltage applying device 30 applies a discharge voltage to the respective coaxial electrodes 11 so as to reverse the polarities thereof. The voltage applying device 30 includes, in this example, a positive voltage source 32, a negative voltage source 34, and a trigger switch 36.

The positive voltage source 32 applies a positive discharge voltage, which is higher than that of the guide electrode 14, to the center electrode 12 of one (in this example, left) coaxial electrode 11.

The negative voltage source 34 applies a negative discharge voltage, which is lower than that of the guide electrode 14, to the center electrode 12 of the other (in this example, right) coaxial electrode 11.

The trigger switch 36 applies positive and negative discharge voltages to the respective coaxial electrodes 12 by operating the positive voltage source 32 and the negative voltage source 34 at the same time.

With this structure, the plasma light source of the invention seals the plasma in the axial direction by forming a tubular discharge between the pair of coaxial electrodes 11.

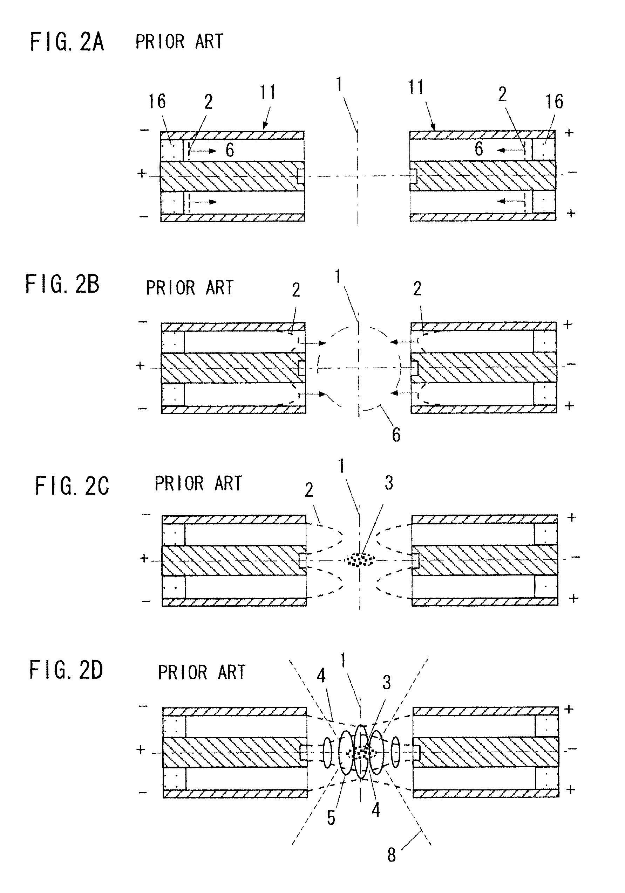

Figs. 2A to 2D are diagrams illustrating the operation of the plasma light source of Fig. 1. In these drawings, Fig. 2A shows the state where a planar discharge is generated, Fig. 2B shows the state where the planar discharge moves, Fig. 2C shows the state where the plasma is formed, and Fig. 2D shows the state where the plasma confining magnetic field is formed.

Hereinafter, a method of generating plasma light will be described by referring to these drawings.

In the method of generating plasma light, the above-described pair of coaxial electrodes 11 is disposed so as to face each other, a plasma medium is supplied into the coaxial electrodes 11 by the discharge environment maintaining device 20 while the temperature and the pressure appropriate for the generation of plasma are maintained, and discharge voltages having reversed polarities are applied to the respective coaxial electrodes 11 by the voltage applying device 30.

As shown in Fig. 2A, due to this voltage application, a planar discharge current (hereinafter, referred to as a planar discharge 2) is generated in the surface of the insulator 16 in the pair of coaxial electrodes 11. The planar discharge 2 is a planar discharge current that spreads two-dimensionally, and hereinafter, referred to as a "current sheet".

Further, at this time, a positive voltage (+) is applied to the center electrode 12 of the left coaxial electrode 11, a negative voltage (-) is applied to the guide electrode 14, a negative voltage (-) is applied to the center electrode 12 of the right coaxial electrode 11, and a positive voltage (+) is applied to the guide electrode 14.

As shown in Fig. 2B, the planar discharge 2 moves in the direction where the discharge is discharged from the electrode by the magnetic field thereof (the direction toward the center in the drawing).

As shown in Fig. 2C, when the planar discharge 2 reaches the front ends of the pair of coaxial electrodes 11, the plasma medium 6 interposed between the pair of planar discharges 2 increases in both density and temperature, and a single plasma 3 is formed at the intermediate position (the symmetry plane 1 of the center electrode 12) between the opposite coaxial electrodes 11.

Furthermore, in this state, the pair of opposite center electrodes 12 has a positive voltage (+) and a negative voltage (-) and the pair of opposite guide electrodes 14 also has a positive voltage (+) and a negative voltage (-). Accordingly, as shown in Fig. 2D, the planar discharges 2 are connected to a tubular discharge 4 which is discharged between the pair of opposite center electrodes 12 and the pair of opposite guide electrodes 14. Here, the tubular discharge 4 indicates a discharge current which surrounds the axis Z-Z and has a hollow cylindrical shape.

When the tubular discharge 4 is formed, a plasma confining magnetic field (a magnetic bin) indicated by the reference numeral 5 in the drawing is formed, so that the plasma 3 may be sealed in the radial direction and the axial direction.

That is, the magnetic bin 5 has a shape in which the center is large and both sides becomes smaller due to the pressure of the plasma 3, an axial magnetic pressure gradient is formed toward the plasma 3, and the plasma 3 is confined at the center position by the magnetic pressure gradient. Furthermore, the plasma 3 is compressed (Z-pinched) toward the center by the magnetic field of the plasma current and is also confined in the radial direction by the magnetic field thereof.

In this state, when energy corresponding to the emission energy of the plasma 3 is continuously supplied from the voltage applying device 30, it is possible to stably generate the plasma light 8 (EUV) for a long period of time with a high energy converting efficiency.

According to the above-described device and method, the pair of opposite coaxial electrodes 11 is provided, the planar discharge current (the planar discharge 2) is generated from each of the pair of coaxial electrodes 11, the single plasma 3 is formed at the intermediate position between the opposite coaxial electrodes 11 by the planar discharge 2, and then the planar discharges 2 are connected to the tubular discharge 4 between the pair of coaxial electrodes to thereby form the plasma confining magnetic field 5 (the magnetic bin 5) which seals the plasma 3, thereby stably generating the plasma light for EUV radiation for a long period of time (with an order of $\mu$sec).

Further, since the single plasma 3 is formed at the intermediate position between the pair of opposite coaxial electrodes 11 and the energy converting efficiency may improve to a large extent (10 times or more) compared to the capillary discharge or the vacuum photoelectric metal plasma of the related art, the thermal load of each electrode at the time of forming of plasma decreases, and the damage caused by the thermal load of the components may be remarkably reduced.

Further, since the plasma 3 which is the light source of the plasma light is formed at the intermediate position between the pair of opposite coaxial electrodes 11, it is possible to increase the effective radiation solid angle of the generated plasma light.

However, although the energy converting efficiency may remarkably improve compared to the related art by the plasma light source, the energy converting efficiency is still low (for example, about 10%), and the output of the plasma light which may be generated with respect to 1 kW of power input to the light source unit is merely about 0.1 kW. For this reason, when the power input to the light source unit largely increases in order to attain the output (for example, 1 kW) of the plasma light demanded in a lithography light source, the thermal load excessively increases, the electrode is highly consumed, and the life span of the device may be shortened.

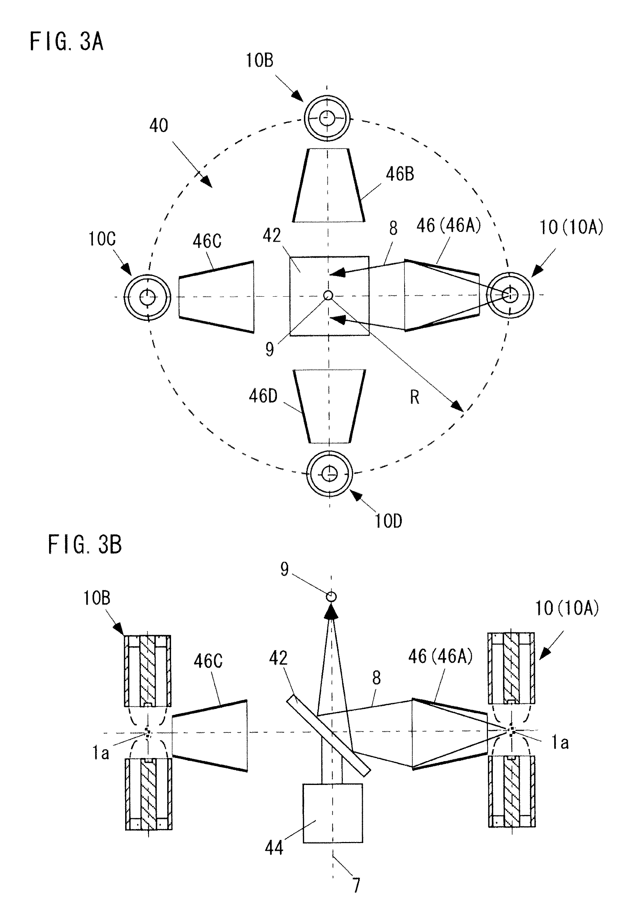

Figs. 3A and 3B are diagrams showing a first embodiment of the plasma light source system according to the invention, where Fig. 3A is a plan view and Fig. 3B is a side view.

In these drawings, the plasma light source system of the invention includes a plurality of (in this example, four) plasma light sources 10 (in this example, 10A, 10B, 10C, and 10D) and a light collecting device 40.

Each of the plurality of (four) plasma light sources 10 (10A, 10B, 10C, and 10D) periodically emits the plasma light 8 from a predetermined light emitting point la. It is desirable that the period be 1 kHz or more, the light emitting time of the plasma light be 1 $\mu$sec or more, and the output of the plasma light be 0.1 kW or more. Further, it is desirable that the periods, the light emitting times, and the outputs of the respective plasma light sources 10 be the same.

Further, as shown in Fig. 1, each plasma light source 10 includes the pair of opposite coaxial electrodes 11, the discharge environment maintaining device 20 that supplies the plasma medium into the coaxial electrode 11 while the temperature and the pressure appropriate for the generation of plasma are maintained, and the voltage applying device 30 that applies discharge voltages having reversed polarities to the respective coaxial electrodes 11, and the tubular discharge is formed between the pair of coaxial electrodes 11 so as to seal the plasma in the axial direction.

The light collecting device 40 collects the plasma light 8 emitted from the plurality of light emitting points 1a of the plasma light sources 10 to a single light collecting point 9.

In this example, the plurality of light emitting points la of the plasma light sources 10 are installed on the same circumference about a single center axis 7. It is desirable to set the distances on the circumference so as to be equal to each other.

Further, in this example, the light collecting device 40 includes a single reflection mirror 42, a single rotation device 44, and a plurality of (in this example, four) light collecting mirrors 46 (in this example, 46A, 46B, 46C, , and 46D).

The reflection mirror 42 is positioned on the center axis, and is configured to reflect the plasma light 8 emitted from each light emitting point la of the plasma light source 10 toward the light collecting point 9 positioned on the center axis 7. The reflection mirror 42 may be desirably a concave mirror, but may be a plane mirror.

The rotation device 44 is configured to rotate the reflection mirror 42 about the center axis 7 so that the reflection mirror 42 faces the plasma light source when plasma light is emitted from each plasma light source 10.

The plurality of (four) light collecting mirrors 46 (46A, 46B, 46C, and 46D) collects the plasma light 8 emitted from the respective light emitting points la toward the reflection mirror 42.

Further, the light collecting mirrors 46 and the reflection mirror 42 are both set to a shape in which they collect the plasma light 8 emitted from the respective light emitting points la to the single light collecting point 9.

Furthermore, it is desirable to install the discharge environment maintaining device 20 and the voltage applying device 30 constituting the plasma light source 10 at each of the plurality of plasma light sources 10, but a part or all of them may be shared.

Furthermore, in the embodiment, the plasma light sources 10 are provided as many as four units, but two or three units or five units may be provided. Further, especially, it is desirable that the number of units become larger in order to shorten the light emitting interval and perform the highly repetitive operation (1 to 10 kHz), and for example, 10 units or more are desirable.

For example, when in Fig. 3, the radius of the circle about the center axis 7 is denoted by R, the rotation speed is denoted by N, and the pulse width of the plasma light 8 is denoted by $\tau$, the plasma movement amount A during discharge is expressed by $2\pi R \cdot N \cdot \tau$. Then, when N is 100 (10 heads and 1 kHz), $\tau$ is 5 $\mu$s, and R is 5 cm, the plasma movement amount $\Delta$ is about 160 $\mu$m, and the size may be set to a microscopic size which may be applied to the EUV plasma light source.

According to the first embodiment of the invention, the plurality of plasma light sources 10 is installed on the same circumference, the light collecting point 9 obtained by the light collecting system including the light collecting mirror 46 and the reflection mirror 42 is formed on the center axis of the circle, the reflection mirror 42 installed at the center of the circle is disposed so as to collect light on the perpendicular axis passing the center of the circle, and them the reflection surface of the reflection mirror 42 is rotated so as to face the plasma light source 10 in a manner of being synchronized with the light emitting timing of the individual plasma light source 10 disposed on the circumference, thereby periodically emitting the plasma light which has a high output and a microscopic size from the single light collecting point 9.

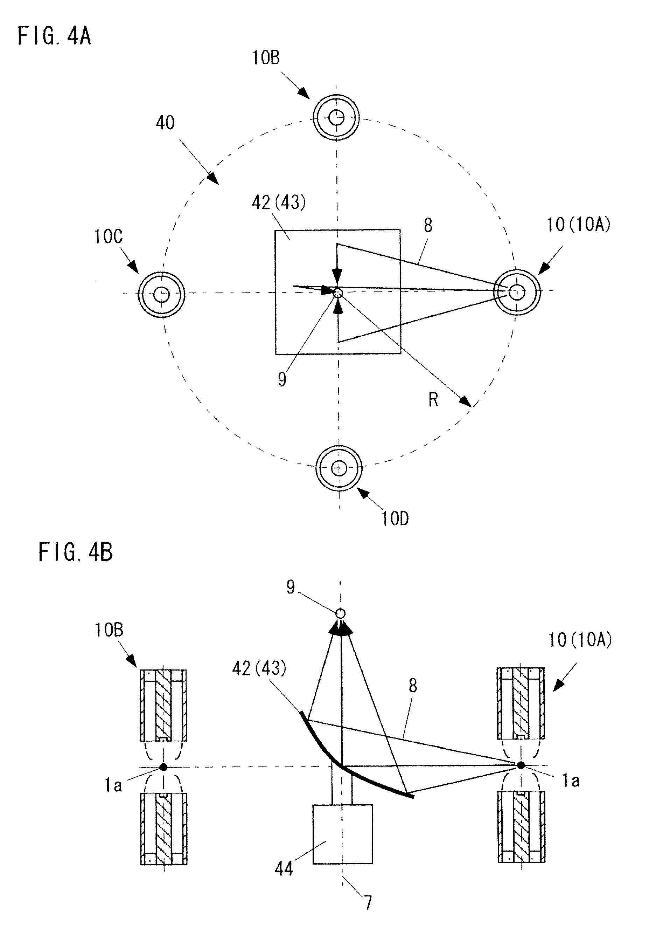

Figs. 4A and 4B are diagrams showing a second embodiment of the plasma light source system according to the invention. In this example, the reflection mirror 42 is a concave mirror 43 which collects the plasma light 8 emitted from the respective light emitting points la toward the light collecting point 9 on the center axis 7.
The other structures are the same as those of the first embodiment.

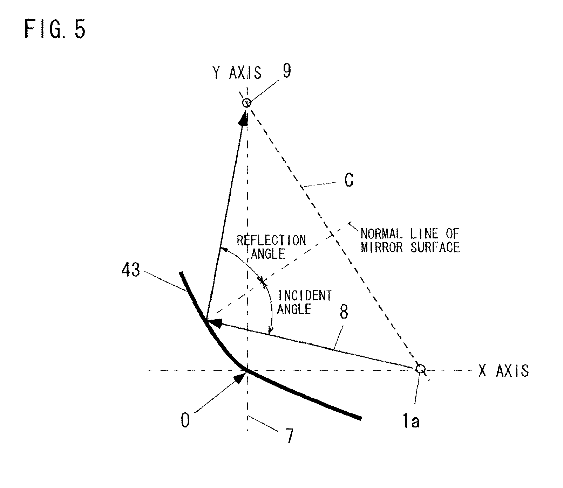

Fig. 5 is a diagram showing a first embodiment of the concave mirror 43 of Fig. 4B.
In Fig. 5, the intersection point between the plane including the plurality of light emitting points la and the center axis 7 is set to the original point O, the line connecting the original point O and the light emitting point la is set to the X axis, the line connecting the original point O and the light collecting point 9 positioned on the center axis 7 is set to the Y axis, and the line connecting the light emitting point la and the light collecting point 9 is set to the symmetrical axis C.

In Fig. 5, the concave mirror 43 is a multilayer film mirror and the reflection surface is formed in a shape in which the incident angle and the reflection angle with respect to the normal line of the reflection surface are equal to each other and are line-symmetrical to each other with respect to the symmetrical axis C.

According to the second embodiment of the invention, it is possible to collect the plasma light 8 emitted from the respective light emitting points la to the light collecting point 9 positioned on the center axis 7 by the single concave mirror 43.
Accordingly, since the reflection surface of the concave mirror 43 is rotated so as to face the plasma light source 10 in a manner of being synchronized with the light emitting timing of the individual plasma light source 10 disposed on the circumference, it is possible to periodically emit the plasma light 8 which has a high output and a microscopic size from the single light collecting point 9.

Further, since the mirror of the EUV range has low reflectivity (for example, about 70%), it is known that the utilization efficiency of the generated EUV light is greatly degraded in the structure with a plurality of mirrors.
Conversely, in the structure of Fig. 5, since the plasma light 8 is collected to the light collecting point 9 by single reflection using the single concave mirror 43, the reflection efficiency may be made to be high and the utilization efficiency of the generated EUV light may be made to be large.

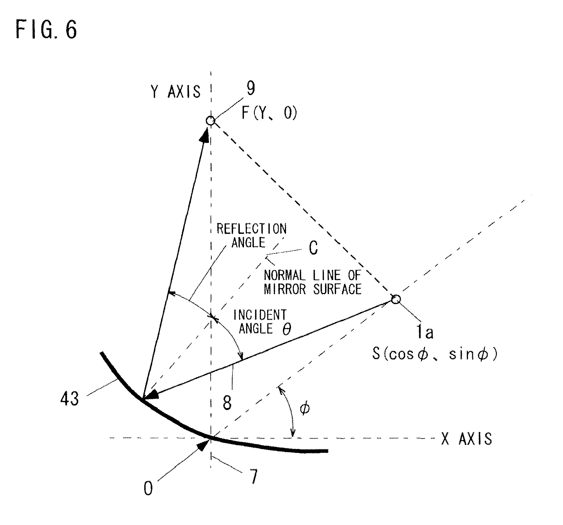

Fig. 6 is a diagram showing a second embodiment of the concave mirror 43 of Fig. 4B.
In Fig. 6, the concave mirror 43 is a multilayer film mirror and the reflection surface is formed in a shape in which the incident angle and the reflection angle with respect to the normal line of the reflection surface are equal to each other and are line-symmetrical to each other about the symmetrical axis C. Further, in this example, the angle $\varphi$ which is formed by the line, connecting the intersection point O between the concave mirror 43 and the center axis 7 and each light emitting point la, with respect to the X axis is not 0° and is set to, for example, 10 to 45°. Furthermore, the respective light emitting points la may be set at the negative side of the Y axis and the angle $\varphi$ may be set to be negative.
In this case, the curve on the X-Y plane of the reflection surface of the concave mirror 43 is expressed by Equation 1.
Here, the position of each light emitting point la and the position on the X-Y axis of the light collecting point 9 are set to S(cos$\varphi$, sin$\varphi$) and F(Y, 0).
The other structures are the same as those of Fig. 5.
This curve becomes an elliptic arc which passes the point O with the points S and F set to two focal points.
The mirror curved surface is a curved surface which is obtained by rotating the curve on the X-Y plane about the symmetrical axis C by a predetermined angle.

[Equation 1]

$$\frac{dy}{dx} = \frac{-(y-Y)\sqrt{(x-\cos\phi)^2+(y-\sin\phi)^2} + (y-\sin\phi)\sqrt{x^2+(y-Y)^2}}{(x-\cos\phi)\sqrt{x^2+(y-Y)^2} - x\sqrt{(x-\cos\phi)^2+(y-\sin\phi)^2}} \quad \cdots (1)$$

By the structure of Fig. 6, it is possible to remove the incident angle area where the incident angle of the plasma light 8 to the concave mirror 43 is less than 45° and the reflectivity of the P polarization component (where the electric field vibration is parallel to the incident surface) is O.
The other effects are the same as those of Fig. 5.

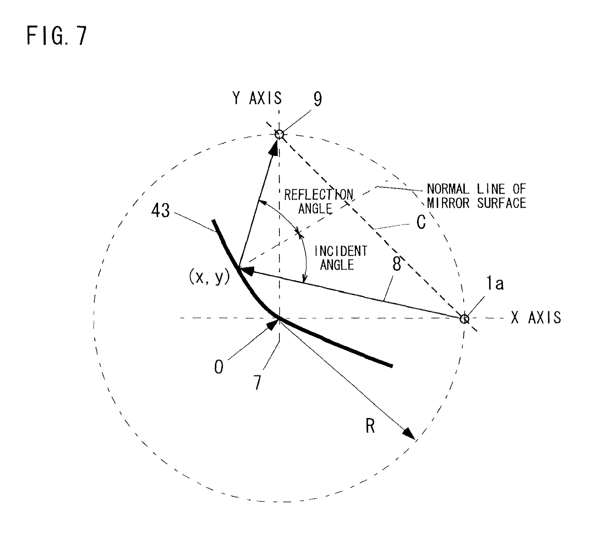

Fig. 7 is a diagram showing a third embodiment of the concave mirror 43 of Fig. 4B.

In Fig. 7, the concave mirror 43 is a multilayer film mirror and the reflection surface is formed in a shape in which the incident angle and the reflection angle with respect to the normal line of the reflection surface are equal to each other and are line-symmetrical to each other with respect to the symmetrical axis C. Further, in this example, the distance from the original point O to each light emitting point la (the radius R of the circle about the center axis 7) and the distance to the light collecting point 9 are set to be equal to each other.

In this case, the curve on the X-Y axis of the reflection surface of the concave mirror 43 is expressed by Equation 2. The other structures are the same as those of Fig. 5.

[Equation 2]

$$\frac{dy}{dx} = \frac{-(y-R)\sqrt{(x-R)^2+y^2} + y\sqrt{x^2+(y-R)^2}}{(y-R)\sqrt{x^2+(y-R)^2} - x\sqrt{(x-R)^2+y^2}} \quad \cdots \quad (2)$$

By the structure of Fig. 7, it is possible to collect the plasma light 8 to the light collecting point 9 so as to be symmetrical about the optical axis. Further, in this case, the radiation angle of the plasma light 8 from the light collecting point 9 becomes equal to the radiation angle of the plasma light 8 from the light emitting point 1a.

The other effects are the same as those of Fig. 5.

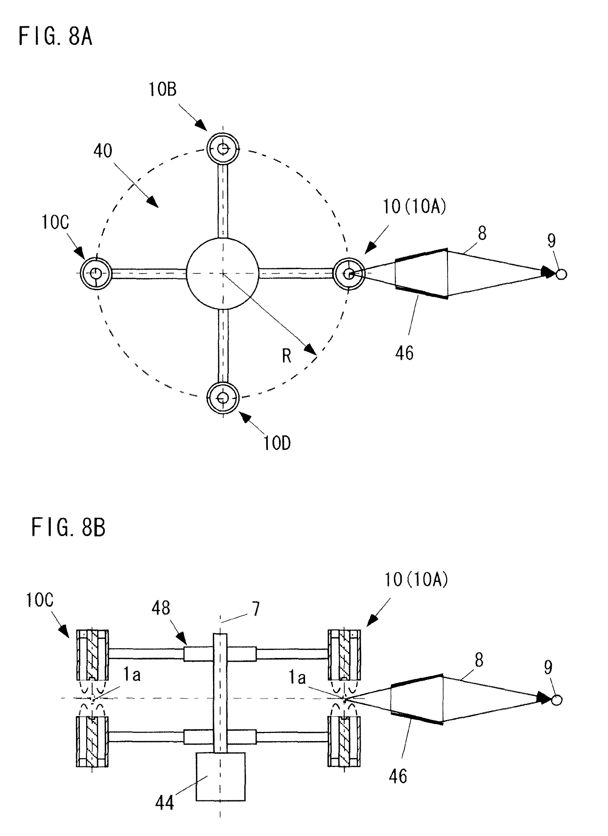

Figs. 8A and 8B are diagrams showing a third embodiment of the plasma light source system according to the invention, where Fig. 8A is a plan view and Fig. 8B is a side view.

In these drawings, the plasma light source system of the invention includes the plurality of (in this example, four) plasma light sources 10 (in this example, 10A, 10B, 10C, and 10D) and the light collecting device 40.

In this example, the light collecting device 40 includes a single rotation body 48, a single rotation device 44, and a single light collecting mirror 46.

The rotation body 48 installs the plurality of (four) light emitting points la of the plasma light sources 10 on the same circumference about the single center axis 7.

The rotation device 44 rotates the rotation body 48 about the center axis 7 so that the light emitting points la of the plasma light source are positioned at a same position (the light emitting point la on the right side of the drawing) when the respective plasma light sources 10 emit plasma light.

Further, the light collecting mirror 46 collects the plasma light 8 from the same position (the light emitting point la on the right side of the drawing) toward the light collecting point 9.

Furthermore, it is desirable that the discharge environment maintaining device 20 and the voltage applying device 30 constituting the plasma light source 10 be provided in each of the plurality of plasma light sources 10, but a part or all of them may be shared.

The other structures are the same as those of the first embodiment.

According to the third embodiment of the invention, the plurality of plasma light sources 10 is installed on the same circumference, the plasma light sources are rotated, and the discharge of the respective plasma light sources 10 and the plasma light emission are performed at the timing at which the respective plasma light sources 10 reach the position facing the light collecting mirror 46, thereby periodically emitting the plasma light which has a high output and a microscopic size from the single light collecting point.

As described above, according to the structure of the invention, since the plurality of plasma light sources 10 which periodically emits the plasma light 8 from the predetermined light emitting points la is provided, when the plasma light sources are sequentially operated, it is possible to remarkably increase the output of the generated plasma light while suppressing the thermal load of the individual light source.

Further, since the light collecting device 40 which collects the plasma light 8 emitted from the plurality of light emitting points la of the plasma light source 10 to the single light collecting point 9 is provided, it is possible to periodically emit the plasma light from the single light collecting point 9 as the lithography EUV light source.

Furthermore, it should be understood that the invention is not limited to the above-described embodiments and all modifications may be included in the scope of the appended claims or the equivalents thereof.

Description of Reference Numerals

| | |
|---|---|
| 1: | symmetry PLANE |
| 1a: | LIGHT EMITTING POINT |
| 2: | PLANAR DISCHARGE (CURRENT SHEET) |
| 3: | PLASMA |
| 4: | TUBULAR DISCHARGE |
| 5: | PLASMA CONFINING MAGNETIC FIELD |
| 6: | PLASMA MEDIUM |
| 7: | CENTER AXIS |
| 8: | PLASMA LIGHT (EUV) |
| 9: | LIGHT COLLECTING POINT |
| 10 (10A, 10B, 10C, 10D): | PLASMA LIGHT SOURCE |
| 11: | COAXIAL ELECTRODE |
| 12: | CENTER ELECTRODE |
| 12a: | RECESSED HOLE |
| 14: | GUIDE ELECTRODE |
| 14a: | OPENING |
| 16: | INSULATOR (POROUS CERAMICS) |
| 18: | PLASMA MEDIUM SUPPLY DEVICE |
| 18a: | RESERVOIR (CRUCIBLE) |
| 18b: | HEATING DEVICE |
| 20: | DISCHARGE ENVIRONMENT MAINTAINING DEVICE |
| 30: | VOLTAGE APPLYING DEVICE |
| 32: | POSITIVE VOLTAGE SOURCE |
| 34: | NEGATIVE VOLTAGE SOURCE |
| 36: | TRIGGER SWITCH |
| 40: | LIGHT COLLECTING DEVICE |
| 42: | REFLECTION MIRROR |
| 43: | CONCAVE MIRROR |
| 46 (46A, 46B, 46C, 46D): | LIGHT COLLECTING MIRROR |

48:                ROTATION BODY

**Claims**

1.  A plasma light source system comprising:

    a plurality of plasma light sources that periodically emits plasma light from predetermined light emitting points; and
    a light collecting device that collects the plasma light from the plurality of light emitting points of the plasma light source to a single light collecting point.

2.  The plasma light source system according to claim 1,
    wherein the plurality of light emitting points of the plasma light sources is installed on a same circumference about a single center axis, and
    wherein the light collecting device includes

    a reflection mirror that is positioned on the center axis and reflects the plasma light from the light emitting points toward the light collecting point, and
    a rotation device that rotates the reflection mirror about the center axis toward the plasma light sources when each plasma light source emits plasma light.

3.  The plasma light source system according to claim 2,
    wherein the light collecting device includes

    a plurality of light collecting mirrors that collects the plasma light of the respective light emitting points toward the reflection mirror, and
    wherein the plasma light of the respective light emitting points is collected to a single light collecting point by the light collecting mirrors and the reflection mirror.

4.  The plasma light source system according to claim 2,
    wherein the light collecting point is positioned on the center axis, and
    wherein the reflection mirror is a concave mirror that collects the plasma light from the light emitting points toward the light collecting point.

5.  The plasma light source system according to claim 4,
    wherein a distance from an intersection point between a plane including the plurality of light emitting points and the center axis to each light emitting point and a distance to each light collecting point are set to be equal to each other.

6.  The plasma light source system according to claim 1,
    wherein the light collecting device includes

    a rotation body that installs the plurality of light emitting points of the plasma light sources on a same circumference about a single center axis, and
    a rotation device that rotates the rotation body about the center axis so that the light emitting points of the plasma light sources are positioned on a same position when the respective plasma light sources emit plasma light.

7.  The plasma light source system according to claim 6,
    wherein the light collecting device includes a light collecting mirror that collects the plasma light from the same position toward the light collecting point.

8.  The plasma light source system according to claim 1,
    wherein each of the plasma light sources includes

    a pair of opposite coaxial electrodes,
    a discharge environment maintaining device that supplies a plasma medium into the coaxial electrodes while maintaining a temperature and a pressure appropriate for the generation of plasma, and
    a voltage applying device that applies a discharge voltage having reversed polarities to the respective coaxial electrodes, and

wherein a tubular discharge is formed between the pair of coaxial electrodes so as to seal plasma in the axial direction.

FIG. 1

PRIOR ART

FIG. 2A    PRIOR ART

FIG. 2B    PRIOR ART

FIG. 2C    PRIOR ART

FIG. 2D    PRIOR ART

FIG. 3A

FIG. 3B

FIG. 4A

FIG. 4B

FIG. 5

Y AXIS　9

C

NORMAL LINE OF
MIRROR SURFACE

REFLECTION
ANGLE

43

INCIDENT
ANGLE

8

X AXIS

0

7

1a

FIG. 6

FIG. 7

FIG. 8A

FIG. 8B

**INTERNATIONAL SEARCH REPORT**

International application No.

PCT/JP2010/064386

A. CLASSIFICATION OF SUBJECT MATTER
*H01L21/027*(2006.01)i, *G03F7/20*(2006.01)i, *H05G2/00*(2006.01)i

According to International Patent Classification (IPC) or to both national classification and IPC

B. FIELDS SEARCHED

Minimum documentation searched (classification system followed by classification symbols)
H01L21/027, G03F7/20, H05G2/00

Documentation searched other than minimum documentation to the extent that such documents are included in the fields searched
Jitsuyo Shinan Koho          1922-1996   Jitsuyo Shinan Toroku Koho   1996-2010
Kokai Jitsuyo Shinan Koho    1971-2010   Toroku Jitsuyo Shinan Koho   1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2003-282424 A (Ushio Inc.), 03 October 2003 (03.10.2003), paragraphs [0012] to [0016]; fig. 2 (Family: none) | 1-5,8 |
| X | JP 2003-51398 A (Nikon Corp.), 21 February 2003 (21.02.2003), paragraphs [0023] to [0043], [0078] to [0083]; fig. 2 to 3, 9 & US 2003/0053588 A1 & EP 1298965 A2 | 1,6-8 |

☐ Further documents are listed in the continuation of Box C.   ☐ See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>09 November, 2010 (09.11.10) | Date of mailing of the international search report<br>22 November, 2010 (22.11.10) |
|---|---|
| Name and mailing address of the ISA/<br>Japanese Patent Office | Authorized officer |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004226244 A

**Non-patent literature cited in the description**

- **Hiroto Sato et al.** Discharge-Produced Plasma EUV Source for Microlithography. *OQD-08-28*

- **Jeroen Jonkers.** High power extreme ultraviolet (EUV) light sources for future lithography. *Plasma Sources Science and Technology,* 2006, vol. 15, S8-S16